# EUROPEAN PATENT APPLICATION

(11) **EP 4 810 969 A1**
(43) Date of publication of application: **23.09.2026**
(21) Application number: 25877864.6
(22) Date of filing: 01.07.2025
(51) Int. Cl.: G01R 31/327, G01R 31/382, G01R 31/392, G01R 19/165, B60L 3/00

(54) **BATTERY SYSTEM CAPABLE OF DIAGNOSING BATTERY PACK RELAY AND METHOD THEREFOR**

(30) Priority: 08.10.2024 KR 20240136238
(71) Applicant: LG Energy Solution, Ltd., Seoul 07335 (KR)
(72) Inventor: RYU, Dong Won, Daejeon 34122 (KR)
(74) Representative: Plasseraud IP
(86) International application number: PCT/KR2025/009313
(87) International publication number: WO 2026/079585

(57) **Abstract**

The present invention relates to a battery system and method for diagnosing battery pack relay. The system according to an embodiment of the present invention starts with an ECU transmitting a command to close a relay to a master battery management system (MBMS) and respective pack battery management systems (PBMSs), when the vehicle is started. The MBMS that receives the command collects a current value of a junction box (J/B), compares the current value with first and second threshold values, adjusts the current value, and then transmits the adjusted current value to each PBMS. Finally, each PBMS again compares the adjusted J/B current value received from the MBMS and a current value of its own pack with third and fourth threshold values, and precisely diagnoses whether the pack relay has an open fault based on the result.

## Description

### TECHNICAL FIELD

The present invention relates to a battery pack protection device and method, and more particularly, to a battery system capable of battery pack relay diagnosis by applying a bidirectional open fault detection logic, and a method for the same.

### BACKGROUND ART

A battery system may include a plurality of battery packs connected in parallel in a junction box (J/B). Power may be supplied to a vehicle from the plurality of battery packs through the junction box. As the number of battery packs connected in parallel increases, the battery system may supply more power. Each of the plurality of battery packs includes a battery pack relay connected to the junction box and a pack battery management system (PBMS) that controls the operation of the battery pack relay. When the relay for each of the plurality of battery packs is closed and the relay in the junction box is closed, power may be supplied to the vehicle from each battery pack.

The PBMS is a system that monitors and manages the battery pack, and controls the battery pack relay to close after the PBMS wakes up. Then, the PBMS determines whether the battery pack relay is normally closed. Hereinafter, an operation of determining whether the battery pack relay is normally closed or whether it fails to open or properly open when it should open is referred to as battery pack relay diagnosis.

Specifically, for battery pack relay diagnosis, the PBMS measures a voltage at each end of the battery pack relay and compares the voltages at both ends. However, since one end of each of a plurality of battery pack relays is connected to the junction box through a single link bus bar, a voltage at one end of a non-closed pack relay among the plurality of battery pack relays may also become similar to the voltage of the battery pack. Therefore, in a battery pack relay diagnosis method in the related art, since battery pack relay diagnosis is performed sequentially on the plurality of battery pack relays one by one, there is a problem in that a considerable amount of time is required for battery pack relay diagnosis.

In order to solve the problem, research is currently being conducted to perform battery pack relay diagnosis by applying an open fault detection logic.

The open fault detection logic is a logic that detects electrical problems that occur when a circuit is opened (broken), for example, when a battery pack is not properly connected or the circuit is broken. This open fault detection logic is applied to ISUZU vehicles, but there is a limitation that the logic applies only to the PBMS that manages up to 12 battery packs installed in an ISUZU vehicle.

However, the number of battery packs installed in each vehicle may be different, and there may be cases where a threshold value needs to be adjusted to monitor and manage a current (junction box current (J/B current)) of each battery pack in the PBMS. In addition, more monitoring time may be required to check whether the current flowing through the battery pack is stable. That is, since the number of battery packs varies by vehicle, the threshold value for monitoring the J/B current of each battery pack needs to be adjusted, and a longer monitoring time may be required to check whether the stability of the J/B current.

In order for the PBMS software to operate the open fault detection logic to meet these requirements, changes have to be made for adjustment and monitoring of the software, but the process and management for changing this PBMS software are complex and difficult, which present a challenge.

As described above, the open fault detection logic applied to the ISUZU vehicle requires adjustment according to the number and state of each battery pack, but making and managing these changes in the software presents a significant challenge.

### Examples of the related art include the following prior art documents

(Patent Document 1) Korean Patent Laid-Open Publication No. 2023-0135715A (September 26, 2023)
(Patent Document 2) Korean Patent Laid-Open Publication No. 2021-0058717A (May 24, 2021)

### DISCLOSURE OF THE INVENTION

### TECHNICAL PROBLEM

The present invention is directed to providing a battery system and method capable of battery pack relay diagnosis by applying a bidirectional open fault detection logic.

The present invention is directed to providing a battery system and method capable of battery pack relay diagnosis by applying an open fault detection logic to a master battery management system (MBMS) to prevent over-detection and false detection of the open fault detection logic.

### TECHNICAL SOLUTION

In accordance with an exemplary embodiment, there is provided a battery system for diagnosing a battery pack relay, the battery system including an engine control unit (ECU) configured to, when a vehicle ignition switch is turned on, transmit a command to close each battery pack relay to a master battery management system (MBMS) and respective pack battery management systems (PBMSs) of two or more battery packs, which constitute a vehicle battery system, the MBMS configured to, when the command to close the battery pack relay is received from the ECU, collect a junction box current value (J/B current value) from a junction box, compare a current value of each battery pack and the J/B current value with a first threshold value and a second threshold value, adjust the J/B current value according to a comparison result, and transmit the adjusted value to the PBMS mounted on each battery pack, and the PBMS configured to, when the command to close the battery pack relay is received from the ECU, compare the J/B current value received from the MBMS and the current value of each battery pack with a third threshold value and a fourth threshold value and diagnose a pack relay open fault according to a comparison result.

The MBMS may determine that a first condition is satisfied when at least one battery pack current value among the battery pack current values of the respective battery packs transmitted from the battery packs mounted on the vehicle is less than the first threshold value and determine that a second condition is satisfied when the J/B current value is greater than the second threshold value.

The first threshold value may be |0.2 [A]|, and the second threshold value may be |30 [A]|.

The MBMS may determine that the first condition is satisfied when the first condition is maintained for a predetermined first reference time or longer.

The MBMS may transmit the J/B current value to the PBMS as it is when both the first condition and the second condition are satisfied, and adjust the J/B current value to 0 [A] and then transmit the adjusted J/B current value to the PBMS when either the first condition or the second condition is not satisfied.

The MBMS may include a current comparison unit configured to compare the J/B current value with the first threshold value and the second threshold value and a current setting unit configured to set the J/B current value transmitted to the PBMS mounted on each battery pack to an adjusted J/B current value based on a comparison result of the current comparison unit.

The PBMS may transmit, to the MBMS, each battery pack current value collected from each battery pack connected to the PBMS.

The third threshold value may be |5 [A]| and the fourth threshold value may be |0.2 [A]|.

The PBMS may determine that a third condition is satisfied when the J/B current value is greater than the third threshold value and determine that a fourth condition is satisfied when the battery pack current value of each battery pack is less than the fourth threshold value.

The PBMS may determine that the third condition is satisfied when the third condition is maintained for a predetermined second reference time or longer.

A pack relay open fault may be diagnosed when both the third condition and the fourth condition are satisfied.

The PBMS may include a diagnosis unit configured to compare the J/B current value with the current value of each battery pack collected from the battery packs respectively connected to the PBMS and diagnose a pack relay open fault based on a comparison result.

The battery system capable of diagnosing the battery pack relay further includes a battery pack relay positioned between each battery pack and the junction box, which receives a control signal of the PBMS and opens and closes an electrical connection between the battery pack and the junction box, a battery pack connected to each battery pack relay and supplying energy according to the operation of the battery pack relay, and a junction box connected to the battery pack relay of each battery pack and connecting and protecting an electric circuit of each battery pack, and connected to the MBMS and supplying current from the battery pack to an external load.

In accordance with an exemplary embodiment, a method for diagnosing a battery pack relay includes (A) a step of turning on a vehicle ignition switch, (B) a step of receiving a command to close a battery pack relay from an ECU, by two or more PBMSs and an MBMS, (C) a step of transmitting, at each PBMS, a current value of each battery pack collected from the battery pack connected to the PBMS to the MBMS, (D) a step of collecting, at the MBMS, a J/B current value from a junction box connected to the MBMS, (E) a step of comparing, at the MBMS, the current value of each battery pack transmitted from the PBMS and the J/B current value with a first threshold value and a second threshold value, and transmitting an adjusted J/B current value according to a comparison result to the PBMS mounted on each battery pack, and (F) a step of comparing, at each PBMS, the J/B current value transmitted from the MBMS and the current value of each battery pack with a third threshold value and a fourth threshold value, and diagnosing a pack relay open fault according to a comparison result.

The step (E) may include a first comparison step of comparing a battery pack current values of the respective battery packs with a first threshold value, a step of determining that the first condition is satisfied when at least one battery pack current value among the battery pack current values is less than the first threshold value as a result of the first comparison, a second comparison step of comparing the J/B current value with a second threshold value when the first condition is satisfied as the result of the first comparison, a step of determining that the second condition is satisfied when the J/B current value is greater than the second threshold value as a result of the second comparison, a step of transmitting the J/B current value to the PBMS mounted on each battery pack when both the first condition and the second condition are satisfied; and a step of adjusting the J/B current value to 0 [A] and then transmitting the adjusted J/B current value to the PBMS mounted on each battery pack when either the first condition or the second condition is not satisfied.

The step (F) may include a third comparison step of comparing the J/B current value with a third threshold value, a step of determining that a third condition is satisfied when the J/B current value is greater than the third threshold value as a result of the third comparison, a fourth comparison step of comparing the received current values of each battery pack with a fourth threshold value when the third condition is satisfied as the result of the third comparison, a step of determining that a fourth condition is satisfied when the battery pack current value is less than the fourth threshold value as a result of the fourth comparison, and a step of diagnosing a pack relay open fault when both the third condition and the fourth condition are satisfied.

### ADVANTAGEOUS EFFECTS

According to an embodiment of the present invention, by applying an open fault detection logic to a master battery management system (MBMS) instead of a pack battery management system (PBMS) that is relatively difficult to change, over-detection and false detection of the open fault detection logic can be prevented.

### BRIEF DESCRIPTION OF THE DRAWINGS

FIG. 1 is a diagram illustrating a configuration of a battery system capable of battery pack relay diagnosis according to an embodiment of the present invention; and
FIG. 2 is a flowchart for describing a method for diagnosing a battery pack relay according to an embodiment of the present invention.

### MODE FOR CARRYING OUT THE INVENTION

Hereinafter, exemplary embodiments of the present invention will be described in detail with reference to the accompanying drawings. However, the present invention is not limited to the exemplary embodiments disclosed below, but will be implemented in a variety of different forms. The exemplary embodiments of the present invention are only provided to allow the present invention to be complete, and to completely inform those skilled in the art of the scope of the disclosure. Here, the drawings may be exaggerated to describe the disclosure in detail, and like reference numerals refer to like elements in the drawings.

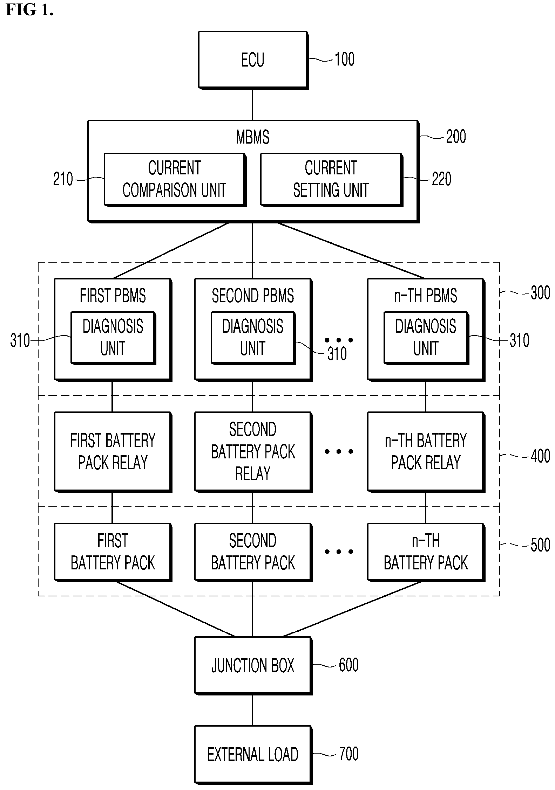

FIG. 1 is a diagram illustrating a configuration of a battery system capable of battery pack relay diagnosis according to an embodiment of the present invention.

Referring to FIG. 1, the battery system capable of battery pack relay diagnosis according to the embodiment of the present invention includes an engine control unit (ECU) 100, a master battery management system (MBMS) 200, a pack battery management system (PBMS) 300, a battery pack relay 400, a battery pack 500, and a junction box 600. In this case, a vehicle is equipped with one MBMS and up to 12 battery packs 500, and one PBMS 300 is installed for each battery pack 500.

The ECU 100 is a component that controls an engine and main systems of the vehicle, and transmits a command to close each battery pack relay 400 to the MBMS and each PBMS of two or more battery packs, which constitute the vehicle battery system, when terminal 15 (KL 15) is turned on by turning on a vehicle ignition switch.

When the command to close the battery pack relay 400 is received from the ECU 100 after terminal 15 (KL 15) is turned on, the MBMS 200 collects the junction box current value (J/B current value) from the junction box 600 and monitors a current flowing through each battery pack 500 in real time through the J/B current value. In addition, the current value of each battery pack 500 and the J/B current value of the junction box 600, which have been collected, are compared with a first threshold value and a second threshold value, and the J/B current value is adjusted according to a comparison result and the adjusted value is transmitted to the PBMS 300 mounted on each battery pack 500.

In this case, KL 15 is a circuit that is supplied with power when the vehicle ignition switch is turned on, and when the vehicle ignition switch is in an on position, power is supplied to the KL 15 circuit. That is, the on of KL 15 refers to a state in which the vehicle ignition switch is turned on and power is being supplied to the circuit, which occurs in a state in which the engine of the vehicle is operating or other electrical systems (such as the radio, air conditioner, headlights, dashboard, or the like) of the vehicle are active.

In addition, the first threshold value may be |0.2 [A]|, and the second threshold value may be |30 [A]|. However, the first threshold value and the second threshold value may change depending on the performance and function (purpose) of the battery system.

For example, when the command to close the battery pack relay 400 is received from the ECU 100 after the KL 15 is turned on, the MBMS 200 compares at least one battery pack current value among battery pack current values of the respective battery packs 500 transmitted from the battery packs 500 (up to 12) mounted on the vehicle to determine whether a first condition of Equation 1 below is satisfied (first comparison). In this case, when the first condition of Equation 1 is maintained for a predetermined first reference time, for example, approximately 10 seconds or longer, it may be determined that the first condition is satisfied, so that an additional stabilization time of the battery pack current may be applied to prevent misdiagnosis of the pack relay open fault detection logic.$AnyBatteryPackCurrent < \left|0.2\left[A\right]\right|$

That is, as described in Equation 1, the MBMS 200 determines that the first condition of Equation 1 is satisfied when at least one battery pack current value among the battery pack current values of the respective battery packs 500 is less than|0.2 [A]|, which is the first threshold value.

In addition, when the first condition is satisfied as a result of the first comparison, the MBMS 200 again compares the J/B current value collected from the junction box 600 to determine whether a second condition of Equation 2 below is satisfied (second comparison).$J / B Current value > \left|30\left[A\right]\right|$

That is, as described in Equation 2, the MBMS 200 determines that the second condition of Equation 2 is satisfied when the J/B current value collected from the junction box 600 is greater than |30 [A]|, which is the second threshold value.

In addition, when both the first condition and the second condition are satisfied, the MBMS 200 transmits the J/B current value collected from the junction box 600 as it is to the PBMS 300 mounted on each battery pack 500. In addition, when either the first condition or the second condition is not satisfied, the MBMS 200 adjusts the J/B current value to 0 [A] and then transmits it to the PBMS 300 mounted on each battery pack 500.

The PBMS 300 diagnoses a relay open fault based on the received J/B current and each pack current, but when the actual measured value is not stabilized or is transmitted as it is in a situation in which it does not meet a standard, an incorrect fault diagnosis may occur due to noise or measurement delay. In order to prevent such problems, the MBMS 200 determines whether the first condition and the second condition are satisfied, and when the conditions are not satisfied, masks the J/B current to "0" and transmits it to the PBMS 300.

To this end, the MBMS 200 includes a current comparison unit 210 that compares the J/B current value collected from the junction box 600 with the first threshold value and the second threshold value and a current setting unit 220 that sets the J/B current value transmitted to the PBMS 300 mounted on each battery pack 500 to an adjusted J/B current value based on a comparison result of the current comparison unit 210.

The J/B current value refers to a specific current value of the battery system monitored and managed by the MBMS 200. In the present invention, the J/B current value refers to a total current that is the sum of all currents supplied from the plurality of battery packs connected in parallel, with the total current flowing toward an external load 700 through the junction box 600.

Meanwhile, only one MBMS 200 is mounted on the vehicle and is a component connected to the PBMS 300, the ECU 100, and the junction box 600 to integrate data received from the plurality of PBMSs 300 by collecting states of the battery packs 500 from the PBMSs 300 and transmitting collected state to the ECU 100, thereby enabling management of the entire battery system.

When the command to close the battery pack relay 400 is received from the ECU 100 after terminal 15 (KL 15) is turned on, the PBMS 300 transmits, to the MBMS 200, the current value of each battery pack 500 collected from the battery packs 500 respectively connected to the PBMSs 300. In addition, the PBMS 300 compares the J/B current value received from the MBMS 200 and the current value of each battery pack 500 with a third threshold value and a fourth threshold value and diagnoses a pack relay open fault according to a comparison result. In this case, the pack relay open state means that the battery pack relay 400 is open, and the pack relay open fault indicates that a problem has occurred in the battery pack relay 400 and means that the battery pack relay 400 remains open or the circuit connection is not established due to a mechanical/electrical defect inside the relay despite the command to close, so that the current of the corresponding battery pack does not flow. Meanwhile, when the pack relay open fault is diagnosed, a warning may be transmitted through the MBMS 200 or necessary protective measures may be taken to prevent overcurrent or undercurrent states of the battery system and ensure the stability and efficiency of the battery system.

In this case, the third threshold value may be |5 [A]|, and the fourth threshold value may be |0.2 [A]|. However, the third threshold value and the fourth threshold value may change depending on the performance and function (purpose) of the battery system.

For example, when the PBMS 300 receives the command to close the battery pack relay 400 from the ECU 100 after the KL 15) is turned on, each PBMS 300 compares the J/B current value transmitted from the MBMS 200 to determine whether a third condition of Equation 3 below is satisfied (third comparison). In this case, the PBMS 300 may determine that the third condition of Equation 3 is satisfied when the third condition is maintained for a predetermined second reference time, for example, approximately 5 seconds or longer.$J / B Current value > \left|5\left[A\right]\right|$

That is, as described in Equation 3, the PBMS 300 determines that the third condition of Equation 3 is satisfied when the J/B current value transmitted from the MBMS 200 is greater than |5 [A]|, which is the third threshold value.

In addition, as a result of the third comparison, when the third condition is satisfied, the PBMS 300 again compares the current value of each battery pack 500 collected from the battery pack 500 to determine whether a fourth condition of Equation 4 below is satisfied (fourth comparison).$BatteryPackCurrent < \left|0.2\left[A\right]\right|$

That is, as described in Equation 4, the PBMS 300 determines that the fourth condition of Equation 4 is satisfied when the battery pack current value of each battery pack 500 is less than |0.2 [A]|, which is the fourth threshold value.

In addition, when both the third condition and the fourth condition are satisfied, the PBMS 300 may diagnose a pack relay open fault.

To this end, the PBMS 300 includes a diagnosis unit 310 that compares the J/B current value transmitted from the MBMS 200 with the current value of each battery pack 500 collected from the battery packs 500 respectively connected to the PBMSs 300, and diagnoses a pack relay open fault according to a comparison result.

Meanwhile, up to 12 PBMSs 300 may be mounted on the vehicle, and as components for managing individual battery packs 500, are connected to the pack relays 400 of the respective battery packs 500 to monitor and control the states of the battery packs 500.

The battery pack relay 400 is a component for opening and closing the electrical connection between the battery pack 500 and the junction box 600, and is positioned between each battery pack 500 and the junction box 600 and operates by receiving a control signal from the PBMS 300. That is, the battery pack relay 400 serves as a switch that connects or disconnects the battery pack 500 and the electrical system, and when the battery pack relay 400 is closed, the battery pack and the electrical system are connected so that current may flow, and when the battery pack relay 400 is opened, the connection is cut so that current does not flow.

The battery pack 500 is a component for storing and supplying energy, and is connected to each battery pack relay 400 to supply energy according to the operation of the battery pack relay 400.

The junction box 600 is a component for connecting and protecting the electric circuit of each battery pack 500, is connected to the battery pack relay 400 of each battery pack 500, and is also connected to the MBMS 200 to supply current from the battery pack 500 to the external load 700.

The external load 700 is an external system (e.g., a motor, a vehicle's electrical system, etc.) that uses current generated from the battery pack 500 and is connected to the junction box 600.

With this configuration, by applying the logic related to the detection of the pack relay open fault to the MBMS 200, which is only equipped with one per vehicle, instead of the PBMSs 300, which is relatively difficult to change when a change in the threshold value of the J/B current value and an additional monitoring time for stabilizing the battery pack current are required, since not only the threshold value of the J/B current value may be easily applied, but also an additional stabilization time of the battery pack current for preventing misdiagnosis of the pack relay open fault detection logic may be applied, it is also advantageous in that over-detection and false detection of the pack relay open fault detection logic may be prevented.

Hereinafter, a method for diagnosing a pack relay according to an embodiment of the present invention is described. The method for diagnosing a pack relay according to an embodiment of the present invention may be a method for processing a signal received using the battery system capable of the pack relay diagnosis described above, and accordingly, the contents described above with respect to the battery system capable of the pack relay diagnosis may be applied as they are, and therefore, description of redundant contents may be omitted.

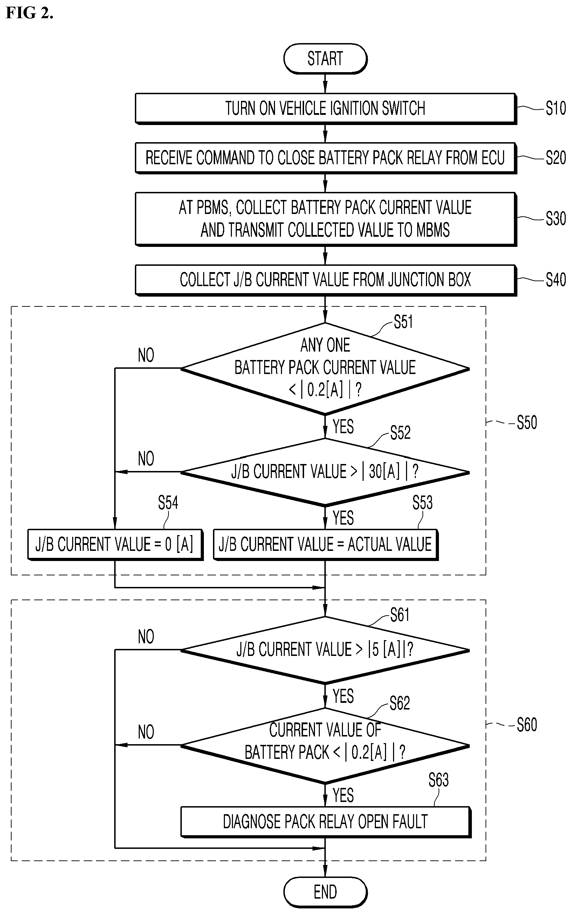

FIG. 2 is a flowchart for describing a method for diagnosing a battery pack relay according to an embodiment of the present invention.

Referring to FIG. 2, in the method for diagnosing a battery pack according to the embodiment of the present invention, first, when the vehicle ignition switch is turned on and terminal 15 (KL 15) is turned on (S10), two or more PBMS 300 and the MBMS 200 receive a command to close the battery pack relay 400 from the ECU 100 (S20).

Then, at the PBMS 300, when the command to close the battery pack relay 400 is received from the ECU 100 after terminal 15 (KL 15) is turned on, a current value of each battery pack 500 collected from the battery packs 500 respectively connected to the PBMSs 300 is transmitted to the MBMS 200 (S30).

In addition, at the MBMS 200, after terminal 15 (KL 15) is turned on, when the command to close the battery pack relay 400 is received from the ECU 100, the J/B current value is collected from the junction box 600 connected to MBMS 200, and the current of each battery pack 500 flowing from the battery pack, which is received from the plurality of PBMS 300, is monitored in real time through the J/B current value (S40). In this case, the J/B current value refers to a specific current value of the battery system monitored and managed by the MBMS 200. Here, the J/B Current value represents the current measurement of the battery pack, and J/B is an abbreviation for "junction box," which may refer to a device that connects and protects the plurality of circuits in an electric circuit.

Subsequently, at the MBMS 200, the current value of each battery pack 500 and the J/B current value of the junction box 600, which have been received from the PBMSs 300, are compared with a first threshold value and a second threshold value, and the J/B current value adjusted according to a comparison result is transmitted to the PBMS 300 mounted on each battery pack 500 (S50).

To describe the above S50 operation in more detail, first, the battery pack current values of the respective battery packs 500 are compared with the first threshold value (|0.2 [A]|) (first comparison) (S51). When at least one battery pack current value among the battery pack current values is less than the first threshold value (|0.2 [A]|) as the result of the first comparison (S51), it is determined that the first condition is satisfied.

In this case, when the first condition is maintained to be satisfied for a first reference time, for example, approximately 10 seconds or longer, it may be determined that the first condition is satisfied, so that an additional stabilization time of the battery pack current may be applied to prevent misdiagnosis of the pack relay open fault detection logic.

In addition, when it is determined that the first condition is satisfied as the result of the first comparison (S51), the J/B current value is compared again with the second threshold value (|30 [A]|) (second comparison) (S52). When the J/B current value is greater than the second threshold value (|30 [A]|) as the result of the second comparison (S52), it is determined that the second condition is satisfied.

When both the first condition and the second condition are satisfied, the J/B current value collected from the junction box 600 is transmitted as it is to the PBMS 300 mounted on each battery pack 500 (S53). In addition, when either the first condition or the second condition is not satisfied, the J/B current value is adjusted to 0 [A] and then the adjusted J/B current value is transmitted to the PBMS 300 mounted on each battery pack 500 (S54).

Subsequently, at each PBMS 300, the J/B current value received from the MBMS 200 and the current value of each battery pack 500 are compared with a third threshold value and a fourth threshold value and a pack relay open fault is diagnosed according to a comparison result (S60). In this case, the pack relay open state refers to a state in which the battery pack relay 400 is open, the pack relay open fault indicates that a problem has occurred in the battery pack relay 400, indicating that the battery pack relay 400 has a problem of maintaining the open state due to an internal defect despite the command to close.

To describe the above S60 operation in more detail, first, the J/B current value transmitted from MBMS 200 is compared with the third threshold value (|5 [A]|) (third comparison) (S61). When the J/B current value is greater than the third threshold value (|5 [A]|) as a result of the third comparison (S61), it is determined that the third condition is satisfied.

In this case, when the third condition is maintained to be satisfied for a predetermined second reference time, for example, approximately 5 seconds or longer, it may be determined that the third condition is satisfied, so that an additional stabilization time of the battery pack current may be applied to prevent misdiagnosis of the pack relay open fault detection logic.

In addition, when it is determined that the third condition is satisfied as the result of the third comparison (S61), the current value of each battery pack 500 collected from the battery pack 500 is compared again with the fourth threshold value (|0.2 [A]|) (fourth comparison) (S62). When the current value of the battery pack 500 is less than the fourth threshold value (|0.2 [A]|) as the result of the fourth comparison (S62), it is determined that the fourth condition is satisfied.

When both the third condition and the fourth condition are satisfied, a pack relay open fault is diagnosed (S63). In addition, when either the third condition or the fourth condition is not satisfied, it is determined that there is no pack relay open fault.

Meanwhile, when the pack relay open fault is diagnosed, a warning may be transmitted through the MBMS 200 or necessary protective measures may be taken to prevent overcurrent or undercurrent states of the battery system and ensure the stability and efficiency of the battery system.

In the above, although preferred embodiments of the present invention have been described and illustrated using specific terms, such terms are only used to clearly describe the present invention, and it is obvious that various modifications and changes may be made to the embodiments of the present invention and the described terms without departing from the spirit and scope of the present invention as defined by the following claims and their equivalents. Such modified embodiments should not be individually understood from the spirit and scope of the present invention, and should be construed as falling within the scope of the claims of the present invention.

Names of the components used in the specification and drawings of the present invention are as follows.

| | | | |
|---|---|---|---|
| 100: | ECU | 200: | MBMS |
| 210: | Current comparison unit | 220: | Current setting unit |
| 300: | PBMS | 310: | Diagnosis unit |
| 400: | Battery pack relay | 500: | Battery pack |
| 600: | Junction box | 700: | External load |

## Claims

1. A battery system for diagnosing a battery pack relay, the battery system comprising:
an engine control unit (ECU) configured to, when a vehicle ignition switch is turned on, transmit a command to close each battery pack relay to a master battery management system (MBMS) and respective pack battery management systems (PBMSs) of two or more battery packs, which constitute a vehicle battery system;
the MBMS configured to, when the command to close the battery pack relay is received from the ECU, collect a junction box current value from a junction box, compare a current value of each battery pack and the junction box current value with a first threshold value and a second threshold value, adjust the junction box current value according to a comparison result, and transmit the adjusted junction box current value to the PBMS mounted on each battery pack; and
the PBMS configured to, when the command to close the battery pack relay is received from the ECU, compare the junction box current value received from the MBMS and the current value of each battery pack with a third threshold value and a fourth threshold value and diagnose a pack relay open fault according to a comparison result.

2. The battery system of claim 1, wherein the MBMS determines that a first condition is satisfied when at least one battery pack current value among the battery pack current values of the respective battery packs transmitted from the battery packs mounted on the vehicle is less than the first threshold value, and determines that a second condition is satisfied when the junction box current value is greater than the second threshold value.

3. The battery system of claim 2, wherein the first threshold value is |0.2 [A]| and the second threshold value is |30 [A]|.

4. The battery system of claim 3, wherein the MBMS determines that the first condition is satisfied when the first condition is maintained for a predetermined first reference time or longer.

5. The battery system of claim 3, wherein the MBMS transmits the junction box current value collected from the junction box to the PBMS as it is when both the first condition and the second condition are satisfied, and adjusts the junction box current value to 0 [A] and then transmits the adjusted junction box current value to the PBMS when either the first condition or the second condition is not satisfied.

6. The battery system of claim 1, wherein the MBMS comprises:
a current comparison unit configured to compare the junction box current value with the first threshold value and the second threshold value; and
a current setting unit configured to set the junction box current value transmitted to the PBMS mounted on each battery pack to an adjusted junction box current value based on a comparison result of the current comparison unit.

7. The battery system of claim 1, wherein the PBMS transmits, to the MBMS, each battery pack current value collected from each battery pack connected to the PBMS.

8. The battery system of claim 1, wherein the third threshold value is |5 [A]| and the fourth threshold value is |0.2 [A]|.

9. The battery system of claim 8, wherein the PBMS determines that a third condition is satisfied when the junction box current value is greater than the third threshold value, and determines that a fourth condition is satisfied when the current value of each battery pack is less than the fourth threshold value.

10. The battery system of claim 9, wherein the PBMS determines that the third condition is satisfied when the third condition is maintained for a predetermined second reference time or longer.

11. The battery system of claim 9, wherein a pack relay open fault is diagnosed when both the third condition and the fourth condition are satisfied.

12. The battery system of claim 1, wherein the PBMS includes a diagnosis unit configured to compare the junction box current value with the current value of each battery pack collected from the battery packs respectively connected to the PBMS and diagnose a pack relay open fault according to a comparison result.

13. The battery system of claim 1, further comprising:
a battery pack relay positioned between each battery pack and the junction box and configured to receive a control signal of the PBMS to open and close an electrical connection between the battery pack and the junction box;
a battery pack connected to each battery pack relay and configured to supply energy according to an operation of the battery pack relay; and
a junction box connected to the battery pack relay of each battery pack to connect and protect an electric circuit of each battery pack and connected to the MBMS to supply current from the battery pack to an external load.

14. A method for diagnosing a battery pack relay, the method comprising:
(A) a step of turning on a vehicle ignition switch;
(B) a step of receiving a command to close a battery pack relay from an ECU, by two or more PBMSs and an MBMS;
(C) a step of transmitting, at each PBMS, a current value of each battery pack collected from the battery pack connected to the PBMS to the MBMS;
(D) a step of collecting, at the MBMS, a junction box current value from a junction box connected to the MBMS;
(E) a step of comparing, at the MBMS, the current value of each battery pack transmitted from the PBMS and the junction box current value with a first threshold value and a second threshold value, and transmitting an adjusted junction box current value according to a comparison result to the PBMS mounted on each battery pack; and
(F) a step of comparing, at each PBMS, the junction box current value transmitted from the MBMS and the current value of each battery pack with a third threshold value and a fourth threshold value, and diagnosing a pack relay open fault according to a comparison result.

15. The method of claim 14, wherein the step (E) comprises:
a first comparison step of comparing a battery pack current values of the respective battery packs with a first threshold value;
a step of determining that a first condition is satisfied when at least one battery pack current value among the battery pack current values is less than the first threshold value as a result of the first comparison;
a second comparison step of comparing the junction box current value with a second threshold value when the first condition is satisfied as the result of the first comparison;
a step of determining that a second condition is satisfied when the junction box current value is greater than the second threshold value as a result of the second comparison;
a step of transmitting the junction box current value to the PBMS mounted on each battery pack when both the first condition and the second condition are satisfied; and
a step of adjusting the junction box current value to 0 [A] and then transmitting the adjusted junction box current value to the PBMS mounted on each battery pack when either the first condition or the second condition is not satisfied.

16. The method of claim 15, wherein the first threshold value is |0.2 [A]| and the second threshold value is |30 [A]|.

17. The method of claim 15, wherein in the step of determining that the first condition is satisfied, it is determined that the first condition is satisfied when the first condition is maintained to be satisfied for a predetermined first reference time or longer.

18. The method of claim 14, wherein the step (F) comprises:
a third comparison step of comparing the junction box current value with a third threshold value;
a step of determining that a third condition is satisfied when the junction box current value is greater than the third threshold value as a result of the third comparison;
a fourth comparison step of comparing the received current values of each battery pack with a fourth threshold value when the third condition is satisfied as the result of the third comparison;
a step of determining that a fourth condition is satisfied when the battery pack current value is less than the fourth threshold value as a result of the fourth comparison; and
a step of diagnosing a pack relay open fault when both the third condition and the fourth condition are satisfied.

19. The method of claim 18, wherein the third threshold value is |5 [A]| and the fourth threshold value is |0.2 [A]|.

20. The method of claim 18, wherein in the step of determining that the third condition is satisfied, it is determined that the third condition is satisfied when the third condition is maintained to be satisfied for a predetermined second reference time or longer.
